# EUROPEAN PATENT APPLICATION

(11) **EP 4 568 465 A1**
(43) Date of publication of application: **11.06.2025**
(21) Application number: 24151302.7
(22) Date of filing: 11.01.2024
(51) Int. Cl.: H10N 60/355, H01F 6/00

(54) **MAGNET PERSISTENT CURRENT SWITCH WITH A SUPERCONDUCTING CONDUCTOR**

(30) Priority: 04.12.2023 US 202363605601 P
(71) Applicant: Koninklijke Philips N.V., 5656 AG Eindhoven (NL)
(72) Inventor: FORTHMANN, Peter, Eindhoven (NL); VOSS, Matthew Jonathan, Eindhoven (NL); VAN LANEN, Ezra Petrus Antonius, 5656AG Eindhoven (NL)
(74) Representative: Philips Intellectual Property & Standards

(57) **Abstract**

A magnet persistent current switch, MPCS, (1) comprises a superconducting wire assembly (10) with connection ports (11) at is ends and formed with a main Its-conductor path (12) of low temperature superconducting material and a parallel hts-shunt (13) of high-temperature superconducting material. The time needed from start of ramping-up until the magnet can be operated is shortened relative to that for a superconductive magnet with a conventional low-temperature material MPCS.

## Description

### FIELD OF THE INVENTION

The invention pertains to a magnet persistent current switch (MPCS) with superconducting conductors. The superconducting conductors of the magnet persistent current switch, when employed in a magnet assembly are circuited to the magnet assembly's windings such that they are in parallel to the windings when in their normal conductive state when the magnet is ramped up/down and in series to the windings and in their superconducting state when the magnet assembly is in persistent mode. The magnet persistent current switch is provided with a heater that is thermally coupled to the conductor of superconducting material to increase the superconducting material above its critical temperate where it becomes electrically resistive. During persistent operation in which the magnet assembly generates a stationary magnetic field, the superconducting conductor is cooled below its superconducting temperature with the magnet windings. This cooling function is carried-out by the magnet assembly's cryogen system.

### BACKGROUND OF THE INVENTION

Such a magnet persistent current switch is known from the US-patent US 9 887 029.

This known magnet persistent current switch contains a wire of a MgB₂-core that is surrounded by a base material of NbTi, which hardly reacts with magnesium and has a high electrical resistivity. Alternatively, stainless steel, may be used, which enhances the mechanical strength. Because of the relatively high critical temperature of MgB₂-material, the cooling time to superconducting of the wire is reduced so that the switching speed of the known magnet persistent current switch is increased.

### SUMMARY OF THE INVENTION

An object of the invention is to reduce the time needed for ramping-up/down of a superconducting magnet with magnet windings of a low-temperature superconducting material.

This object is achieved by the magnet persistent current switch comprising
a superconducting wire assembly) with connection ports at is ends and formed with a main lts-conductor path of low temperature superconducting material and
a parallel hts-shunt of high-temperature superconducting material.

The main lts-conductor path and the parallel hts-shunt are electrically circuited in parallel. During ramping-up/down of the magnet, the MPCS's superconducting wire assembly is heated to a temperature above the critical temperatures of the wire, i.e., above the critical temperature of the high-temperature superconducting material of the parallel hts-shunt, of which the ceramic material is electrically insulating above the critical temperature. This disables conduction of electrical current by the lts and hts material, which are electrically insulating or in any case bad conductors in that electrical conductivity is very low when warm i.e. at temperature above their critical temperature for superconductivity. In practice, where hts- and Its- superconductive materials may be formed as strands embedded in a metal matrix, this leaves the electrical current to be carried by the embedding metal matrix, which has a much lower electrical conductivity compared to the very high electrical conductivity of the cold, i.e. below their critical temperature for superconductivity superconducting magnet coils/windings, which are in parallel with the MPCS. So heating the MPCS to above its critical temperature for superconductivity opens it, and when ramping-up, electrical current from an electrical current source can then be introduced into the magnet coils/windings. When the electrical current strength in the magnet windings reaches a predetermined current level, the MPCS superconducting wire assembly is cooled to below the critical temperature of the parallel hts-shunt and the parallel hts-shunt becomes superconducting, while the lts-lead forming a main lts-conductor path remains normally (nonsuperconducting) electrically resistive. Then, the current from the charging power supply is ramped down, which, by Kirchhoff's current law, causes a current to flow in the (lts shunt part of the) MPCS. When the current supply is completely ramped down, the entire operating electrical current flows in the closed serial circuit composed of magnet coils and the hts-shunt. The parallel hts-shunt experiences only a residual ohmic resistance at contact regions of the parallel hts-shunt with the main lts-lead. Then, the magnet can be operated from the point where the parallel hts-shunt becomes superconducting while cooling of the main lts-conductor path of the main lts-lead continues to below the critical temperature of the main lts-conductor path, which then becomes superconducting as well. Owing to the residual ohmic resistances at the contact regions, the electrical current through the MPCS will transfer naturally from the (very slightly resistive) hts-path to the main lts-conductor path that is persistently jointed to the magnet windings in a conventional manner. Because of the smaller temperature range over which the MPCS needs to be cooled during the final part of the ramping-up/down of the magnet and since thermodynamic cooling efficiency generally increases with temperature, the time needed from start of ramping-up until the magnet can be operated is shortened relative to that for a superconductive magnet with a conventional low-temperature material MPCS.

The MPCS of the invention does not need persistent joints between the hts-material of the MPCS and the magnet windings. The challenge to make persistent joints between hts-material of the MPCS and the magnet windings is circumvented by the present invention in that the persistent joints are provided between the main lts-lead formed by the main lts-conductor path, and the magnet windings; these may be formed conventionally, e.g., based on NbTi-compounds. The hts-material for the parallel hts-shunt may be MgB₂, YBCO-types; YBa₂Cu₃O_{7-*x*} (also known as Y123), and materials with other Y:Ba:Cu ratios exist, such as YBa₂Cu₄O*_{y}* (Y124) or Y₂Ba₄Cu₇O*_{y}* (Y247), or BSSCO-type, generally Bi₂Sr₂Ca_{*n*-I}CunO_{2*n*+4+*x*}.

These and other aspects of the invention will be further elaborated with reference to the embodiments defined in the dependent Claims.

In an embodiment of the MPCS, the parallel hts-shunt is electrically connected at the contact regions with the main lts-conductor path. In these contact regions, electrically conducting contact material is disposed so that an electrical contact is formed by an electrically resistive path between the main lts-conductor path and the parallel hts-shunt. When the temperature is decreased below the critical temperature of the low-temperature superconducting material, there remains a continuous superconducting path through the main lts-conductor path. The residual ohmic resistance at the contact regions to the parallel hts-shunt will cause the current to be carried fully by the main lts-conductor path when the temperature is below the critical temperature of the material of the main lts-conductor path through the continuous current path of low-temperature superconducting material.

In an example of the superconductive wire assembly of the MPCS of the invention, the main lts-conductor path comprises a plurality of low-temperature superconducting lts-strands in a first metal matrix, and the parallel hts-shunt comprises a plurality of high-temperature superconducting hts-strands encased in a second metal matrix, and the main lts-conductor path and the parallel hts-shunts are covered in a tubular cover sheet. This achieves that the superconductor wire assembly is geometrically configured in the form of a cable. The enables simple and robust circuit lay-out that is easy and inexpensive to manufacture.

In a further example of the invention, the main lts-conductor path and the parallel hts-shunt are disposed e.g., encased in a metal matrix. The encasing in a metal matrix improves mechanical and electrical stability of the MPCS. The metal matrix may be formed as a metallic copper matrix.

In a further example of the superconductive wire assembly of the MPCS of the invention at the contact regions the electric contacts are provided by electrically conducting contact material extending between the main lts-conductive path and the parallel hts-shunt. This enables a simple manufacturing of the superconducting wire assembly with the contact regions e.g. by soldering techniques. In the reference frame of the cable containing the main lts-conductive path and the parallel hts-shunt, the main lts-conductor path and the parallel hts-shunt are radially or laterally embedded in the contact material formed as solder patch. The solder patch axially partially covers the main lts-conductor path and the parallel hts-shunt and the solder forms an electrically resistive connection between the main lts-conductor path and the parallel hts-shunt. The lateral and radial directions are mutually orthogonal and each of them is orthogonal to the longitudinal extension of the elongate cable.

In the laterally separated example, in the cross-section of the cable the main lts-conductive path and the parallel hts-shunt are laterally next each other with the electrically conducting contact material between them establishing the resistive electrical contact. In the cross-section of the cable, the main lts-conductor path and the parallel hts-shunt from zones that are laterally next to each other separated by the electrically conducting contact that is electrically resistive. The electrically conducting contact material may in the cross-section of the cable surround the main lts-conductive path and the parallel hts-shunt.

In the radially separated example, in the cross-section of the cable the parallel hts-shunt and the main lts-conductor paths are radially separated and the parallel hts-shunt tangentially surrounds the main lts-conductor path, or *vice versa.* The parallel hts-shunt and the main lts-conductor path may tangentially fully or partially surround each other. That is, in the cross-section of the cable the main lts-conductor path and the parallel hts-shunt from zones that are radially distant and surround each other with the electrically resistive material, e.g. the solder patch at least radially between them. In addition, there may be a region of electrically conductive material radially outward from the main lts-conductive paths and the parallel hts-shunt and surrounding partially or entirely the cross-section of the cable ate the contact region(s). Notably, when solder is used as the electrically resistive material, the mechanical stability of the contact region is enhanced.

In a next example of the invention, the low-temperature superconductive material of the main hts-conductor path is made with a NbTi-compound and the high-temperature superconductive material of the parallel hts-shunt comprises a MgB₂-compound. The metal matrices in which the MgB2-strands and the NbTi-strands, respectively are embedded may contain metallic copper (Cu).

A radial alternation of axially extending MgBz-strands with NbTi-strands in the first metal (copper) matrix achieves that the NbTi-strands form the main lts-conductor path, the MgBz-strands form the parallel hts-shunt, while the NbTi-strands also form diffusion barriers that counteract chemical interaction of the MgB₂ with the second metal (copper) matrix.

In a magnet assembly incorporating the MPCS of the invention, the magnet windings are connected to the connecting ports at the superconductive wire assembly's longitudinal end. The connection ports are longitudinally separated from the contact regions, so that they can be conventionally jointed with the main lts-conducive path.

These and other aspects of the invention will be elucidated with reference to the embodiments described hereinafter and with reference to the accompanying drawing wherein

### BRIEF DESCRIPTION OF THE DRAWINGS

Fig. 1 shows a diagrammatic representation of an example of the MPCS of the invention;
Figs. 2 and 3 show diagrammatic representations of the operation modes of the superconductor wire assembly of the MPCS of the invention at different temperatures,
Fig. 4 shows a transverse cross section of the contact region of Figs. 2 and 3 along the transverse plane A-B and
Fig. 5 shows a transverse cross section of a concentric version of the contact region of Figs. 2 and 3 along the transverse plane A-B.

### DETAILED DESCRIPTION OF THE EMBODIMENTS

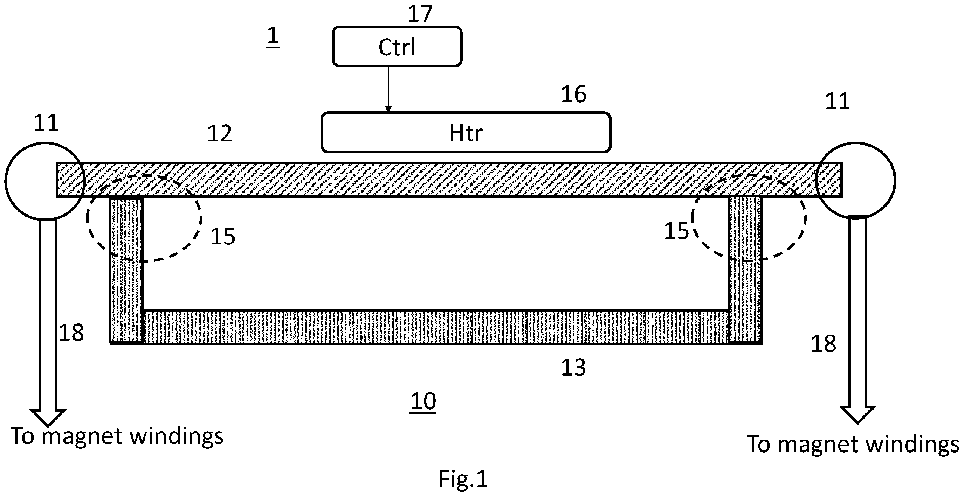

Fig. 1 shows a diagrammatic representation of an example of the MPCS 1 of the invention. The MPCS 1 comprises the superconducting wire assembly 10 with the main lts-conductor path 12 and the parallel hts-shunt 13. The main lts-conductor path extends between the connector ports 11 at which the MPCS is connected to the magnet windings (not shown) when incorporated in a superconducting magnet assembly. The parallel hts-shunt is coupled to the main lts-conductor at the connection regions 15. The heater 16 is controlled by a heating-controller 17. When the magnet assembly is to be ramped-up/down, the heating controller activates the heater to increase the temperature of the main lts-conductor path above its critical temperature so that it becomes normal electrically resistive and an electrical current source (not shown) can be connected in parallel to the superconducting wire assembly 10 over the connector ports 11 so that a voltage is applied over the superconducting wire assembly and the magnet windings and electrical current is introduced into the magnet windings. Towards the end of the ramp-up process, the heater 16 is switched-off and the superconducting wire assembly is cooled by the cryostat system of the magnetic resonance examination system (not shown). When the superconducting wire assembly is cooled to below the critical temperature for superconductivity of the parallel hts-shunt's high-temperature superconducting material, the parallel hts-shunt becomes superconducting and will carry most of the electrical current, and the superconducting wire assembly becomes superconducting apart from ohmic resistive portions at the connection regions 15, where electrical current passes through a transition region from low-temperature superconducting material to high-temperature superconducting material, and where the low-temperature superconducting is in its normal electrical resistive state. This minor electrical resistance allows the magnet windings to be operated albeit not at their full specified magnetic field strength. As cooling continues, the low-temperature material of the main lts-conductor path becomes superconducting as well and when the electrical current source is switched-off can be disconnected from the superconducting wire assembly of the magnet persistent current switch and the magnet operates at its nominal magnetic field strength. When the electrical normal joint resistance is small enough (fractions of micro-ohms), and the parallel hts-shunt is dimensioned accordingly, the magnet can already be operated at full current at this stage.

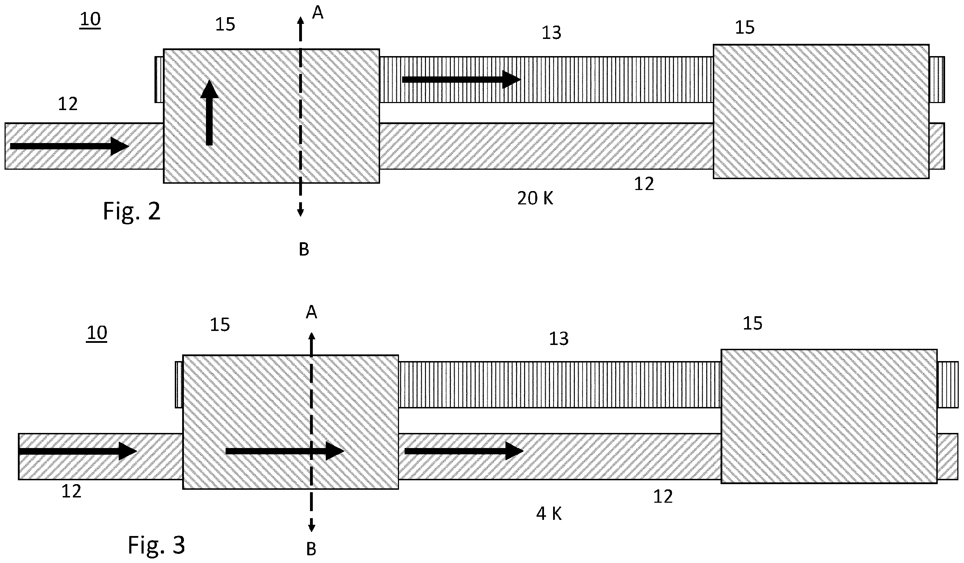

Figs. 2 and 3 show diagrammatic representations of the operation modes of the superconductor wire assembly of the MPCS of the invention at different temperatures. The connector ports 11 and the heater 16 and heating controller 17 are not shown in Figs.2,3. Fig. 2 represents the superconducting wire assembly 10 at a relatively higher temperature below the critical temperature of the parallel hts-shunt's superconducting material but above the critical temperature of the main lts-conductor path's superconducting material. That is, at a temperature, for which the parallel hts-shunt is superconducting, and the main lts-conductor path is in its normal electrical resistive state. This may be at a temperature of about 20K which is above the operating temperature of NbTi (4K) and below the critical temperature of MgB₂ (39K). At the contact regions 15 the main lts-conductor path 12 and the parallel hts-shunt 13 are soldered so that electrical current can pass as indicated by the arrows, from the main lts-conductor path 12 into the parallel hts-shunt 13 and from the parallel hts-shunt 13 to the Its-main conductor path 12, respectively. As the parallel hts-shunt 13 is superconducting, the electrical current will pass through the path of lowest (i.e. zero) electrical resistance through the parallel hts-shunt 13. Fig. 3 represents the superconducting wire assembly 10 at a lower temperature e.g., 4K (at which He is liquid), below the critical temperature of the main lts-conductor's superconducting material. For example, the ltsmain conductor path 12 may comprise NbTi of which the critical temperature is about 10K and the parallel hts-shunt 13 may comprise MgB₂ of which the critical temperature is 39K. Then the electrical current pattern is dominated by the electrical ohmic residual resistivity of the solder of the contact regions 15 remaining normal electrical resistive at 4K. At 4K, i.e., below the critical temperatures of both the ltsmain conductor path and the parallel hts-shunt, the parallel hts-shunt and the main lts-conductor paths are superconductive and have no electrical resistance, while the solder is electrically resistive. Thus, the electrical current will as indicated by the arrows, flows freely through the main lts-conductor paths and will meet with the residual electrical resistance of the solder that prevents the electrical current to cross to the parallel hts-shunt 13.

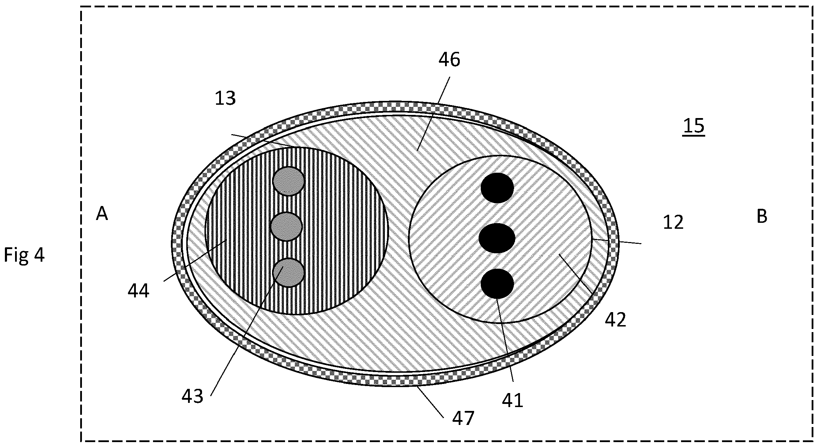

Fig. 4 shows a transverse cross section of the contact region 15 of Figs. 2 and 3 along the transverse plane indicated as A-B. The main lts-conductor path 12 includes a plurality of lts-strands of low-temperature material, such as a NbTi compound strands 41 in a first metal matrix 42 e.g. of copper. The parallel hts-shunt 13 includes a plurality of hts-strands 43 of high-temperature superconducting material, such as an MgB₂-compoud, in a second metal matrix 44 e.g. of copper. At the contact regions 15 the main lts-conductor path 12 and the parallel hts-shunt 13 are (mechanically and electrically) connected by solder 46 e.g., in the form of a patch of solder-matter. The solder provides for the electrically normal, non-superconductive, conducting connection of which the resistance is in the order of a few µΩ and below. The diameter of the hts-strands 43 of MgB₂-compound is about 200µm. The diameter of the lts-strands 41 of NbTi-compound is about 50µm. The main lts-conductor path 12 and the parallel hts-shunt 13 comprising the lts-strands 41 and the hts-strands 43 in the respective metal matrices 42,44, respectively are formed as cables having a diameter of about 0.7mm. The solder may be regular lead-based, lead-free low-temperature e.g., bismuth-based solder, such as Bi₅₆Sn₃₀In₁₄. The superconductor wire assembly is formed as a cable with the tubular sheet 47, which encases the main ltsconductors path and the hts-shunt.

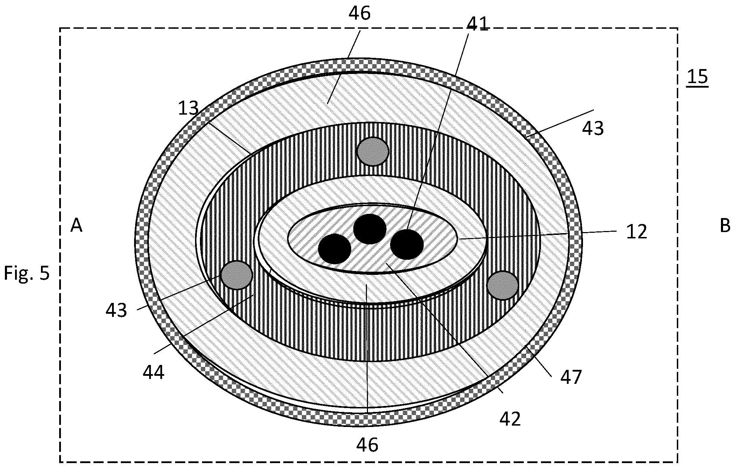

Fig. 5 shows a transverse cross section of a concentric version the of the contact region of Fig. 2 and 3 along the transverse plane A-B. In this example the parallel hts-shunt is arranged radially outside of the main lts-conductor path 12 and the solder region 46 has an outer circumferential layer radially around the parallel hts-shunt and an intermediate layer radially between the main lts-conductor path 12 and the parallel hts-shunt 13. As is already apparent from Fig. 1 and Fig. 2 the solder 46 extends axially only partially at the contact region 15.

## Claims

1. A magnet persistent current switch comprising
a superconducting wire assembly (10) with connection ports (11) at is ends and formed with a main lts-conductor path (12) of low temperature superconducting material and
a parallel hts-shunt (13) of high-temperature superconducting material.

2. A magnet persistent current switch as claimed in Claim 1, wherein the parallel hts-shunt is connected at contact regions to the main lts-conductor path and in each contact region electrically conducting contact material is disposed providing an electrical contact between the main lts-conductor path and the parallel hts-shunt.

3. A magnet persistent current switch of any one of the preceding claims, wherein the main lts-conductor path comprises a plurality of low-temperature superconducting lts-strands encased in a first metal matrix and the parallel hts-shunt comprises a plurality of high-temperature superconducting hts-strands encased in a second metal matrix and the main lts-conductor path and the parallel hts-shunts are covered in a tubular cover sheet.

4. A magnet persistent current switch as claimed in Claim 2 or 3, wherein at the contact regions the electric contacts are provided by electrically conducting contact material extending between the first and second metal matrices.

5. A magnet persistent current switch as claimed in Claim 4, wherein the contact region includes a solder patch formed with the electrically conducting contact material in which the main lts-conductor path and the parallel hts-shunt are radially or laterally displaced and embedded and the solder patch axially partially covering the main lts-conductor path and the parallel hts-shunt, the solder forming an electrically resistive connection between the main lts-conductor path and the parallel hts-shunt.

6. A magnet persistent current switch as claimed in any one of Claims 1 to 5 in which the main hts-conductor path is made of a MgB2-compound and the parallel lts-shunt is made with a NbTi-compound.

7. A magnet persistent current switch as claimed in any one of Claims 1 to 6, wherein the metal-matrix is made with metallic Cu or Cu-Ni alloy.

8. A magnet assembly comprising magnet windings and a magnet persistent current switch of any one of the preceding Claims, wherein the magnet windings are connected to the connecting ports of which one or more are separated from the contact regions laterally along the main conductor path.
